(19) Europäisches Patentamt
European Patent Office
Office européen des brevets

(11) **EP 4 530 790 A1**

(12) **EUROPEAN PATENT APPLICATION**

(43) Date of publication:
02.04.2025 Bulletin 2025/14

(21) Application number: 24202302.6

(22) Date of filing: 24.09.2024

(51) International Patent Classification (IPC):
G05F 3/30 (2006.01)    H03F 3/45 (2006.01)

(52) Cooperative Patent Classification (CPC):
G05F 3/30; H03F 3/45183; H03F 2203/45341;
H03F 2203/45342; H03F 2203/45674

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 29.09.2023  JP 2023170227
06.08.2024  JP 2024130099

(71) Applicant: ABLIC Inc.
Kitasaku-gun, Nagano 389-0293 (JP)

(72) Inventors:
• MARUYAMA, Hiroaki
  Nagano, 389-0293 (JP)
• KUROZO, Tadashi
  Nagano, 389-0293 (JP)
• SAWAI, Hideyuki
  Nagano, 389-0293 (JP)

(74) Representative: Winter, Brandl - Partnerschaft
mbB
Alois-Steinecker-Straße 22
85354 Freising (DE)

(54) **REFERENCE VOLTAGE CIRCUIT**

(57) A reference voltage circuit (100) includes a differential amplifier circuit (10) capable of stably operating at a constant voltage even if a collector voltage of an NPN transistor changes with temperature and is received. A voltage adjustment circuit (30) is included between commonly connected sources and commonly connected back gates of a first PMOS transistor (1) and a second PMOS transistor (2) serving as input parts of a differential amplifier circuit (10). A voltage generated by the voltage adjustment circuit (30) is adjusted to increase a source-back gate voltage of the first PMOS transistor (1) and the second PMOS transistor (2) in accordance with a voltage change in which the collector voltage of the NPN transistor received at one of the input parts of the differential amplifier circuit (10) decreases with a temperature rise.

FIG. 2

**Description**

BACKGROUND

Technical Field

The present invention relates to a reference voltage circuit.

Related Art

A reference voltage circuit is known to differentially amplify two input voltages to output a reference voltage. In a reference voltage circuit including a differential amplifier circuit, a voltage received at an input port of the differential amplifier circuit is, for example, a voltage based on a voltage of a PN junction element with a PN junction surface such as a diode. In the reference voltage circuit including the differential amplifier circuit, to achieve stable constant voltage operation, it is common to cause each transistor constituting the differential amplifier circuit to operate in a saturation region, which is also called a pentode region. A bandgap reference voltage circuit (hereinafter simply referred to as a "reference voltage circuit") using an NPN-type bipolar transistor (hereinafter simply referred to as an "NPN transistor") as the input of the differential amplifier circuit has been proposed (e.g., refer to Patent Document 1).

An example of a conventional differential amplifier circuit included in the reference voltage circuit is a differential amplifier circuit (3) illustrated in FIG. 6 of Patent Document 2. In the differential amplifier circuit (3) illustrated in Patent Document 2, a PMOS transistor (hereinafter simply referred to as a "PMOS transistor") (P32), which is an example of a P-channel field-effect transistor (FET), turns on, and an NMOS transistor (hereinafter simply referred to as an "NMOS transistor") (N31), which is an example of an N-channel FET connected to the drain of the PMOS transistor (P32), turns on, and a first current thus flows through the PMOS transistor (P32) and the NMOS transistor (N31). Further, a PMOS transistor (P33) turns on, an NMOS transistor (N32) connected to the drain of the PMOS transistor (P33) turns on, and a second current thus flows through the NMOS transistor (N32) and the PMOS transistor (P33). The differential amplifier circuit (3) compares and differentially amplifies the first current and the second current to output an output voltage from an output port (at least one of O1 and 02).

As illustrated in FIG. 14 of Patent Document 1, for example, the reference voltage circuit including the conventional differential amplifier circuit generates two voltages (VA and VB) based on the output voltage of the differential amplifier circuit, and receives the two voltages as a first input voltage and a second input voltage of the differential amplifier circuit, respectively, to undergo a negative feedback control and obtain a temperature-independent reference voltage (VREF).

Related Art Documents

Patent Documents

[Patent Document 1] Japanese Patent Application Laid-Open No. H10-303658
[Patent Document 2] Japanese Patent Application Laid-Open No. 2005-136473

SUMMARY

Technical Problem

However, in the conventional reference voltage circuit including a differential amplifier circuit composed of two PMOS transistors and two NMOS transistors as described in Patent Document 1, it is difficult to achieve constant voltage operation at a low power supply voltage of, for example, 2 volts (V) or less. More specifically, in the conventional reference voltage circuit, the voltage supplied to the input port of the differential amplifier circuit may decrease excessively accompanying a change in external temperature.

To achieve stable operation when operating the reference voltage circuit at a constant voltage, it is required to cause each MOS transistor constituting the differential amplifier circuit included in the reference voltage circuit to operate in saturation. Herein, an example will be described, taking the conventional differential amplifier circuit as the differential amplifier circuit (3) described in Patent Document 2, and using a collector voltage of an NPN transistor with the collector and the base connected (so-called diode connection) as the input voltage of the differential amplifier circuit (3).

In the differential amplifier circuit (3), in the case where the voltage applied to the gate of the PMOS transistor (P32) decreases due to an external factor such as a temperature change, the source voltage of the PMOS transistor (P32) decreases. Since the decrease in the source voltage of the PMOS transistor (P32) reduces the drain-source voltage of the PMOS transistor (P32), the PMOS transistor (P32) may become unable to operate in saturation. In other words, the PMOS transistor (P32) may operate in a non-saturation condition. On the other hand, in the case where the voltage applied to the gate of the PMOS transistor (P32) increases, the source voltage of the PMOS transistor (P32) increases, and the drain-source voltage of the PMOS transistor (P31) operating as a current source may decrease and lead to non-saturation operation. Upon non-saturation operation of the PMOS transistor (P31), the PMOS transistor (P31) may become unable to cause a predetermined constant current to flow. Thus, in the conventional circuit configuration, there is a limitation on the required source voltage of the PMOS transistor (P32) (narrow voltage range in which saturation operation is possible), and it is difficult to keep a minimum operating voltage capable of being received as the power supply voltage (VDD) low while causing each MOS transistor to operate in saturation.

Considering the above circumstances, it is an objective of the present invention to provide a reference voltage circuit including a differential amplifier circuit capable of operating stably at a constant voltage while keeping a minimum operating voltage lower than in the conventional art, even if a voltage based on a voltage of a PN junction element, such as a collector voltage of a diode-connected NPN transistor included in the reference voltage circuit, for example, changes due to an external temperature change and is received at the differential amplifier circuit.

Solution to Problem

A reference voltage circuit according to an embodiment of the present invention includes a differential amplifier circuit. The differential amplifier circuit includes: a ground terminal; a first PMOS transistor containing a gate corresponding to a first input port, a source, and a drain; a second PMOS transistor containing a gate corresponding to a second input port, a source connected to the source of the first PMOS transistor, a back gate connected to the back gate of the first PMOS transistor, and a drain; a first NMOS transistor containing a drain connected to the drain of the first PMOS transistor, a gate connected to the drain of the first NMOS transistor and the drain of the first PMOS transistor, a back gate, and a source connected to the back gate of the first PMOS transistor and a ground terminal; a second NMOS transistor containing a drain connected to the drain of the second PMOS transistor, a gate connected to the drain of the second NMOS transistor, a back gate, and a source connected to the back gate of the first PMOS transistor and a ground terminal; and a voltage adjustment circuit. The voltage adjustment circuit includes: a first port connected to commonly connected sources of the first PMOS transistor and the second PMOS transistor; a second port connected to commonly connected back gates of the first PMOS transistor and the second PMOS transistor; and a power supply terminal connected to a power supply port, the voltage adjustment circuit being configured to increase and decrease the voltage generated between the first port and the second port in response to a change in an input voltage of the differential amplifier circuit.

In an embodiment of the present invention, the voltage adjustment circuit may include a current source connected between the power supply terminal and the second terminal, and a resistor connected between the first terminal and the second terminal. The resistor may include a variable resistor which has a temperature coefficient of a polarity reverse to a polarity of a temperature coefficient of a voltage received at the gate of the first PMOS transistor and is capable of adjusting a resistance value.

In an embodiment of the present invention, the voltage adjustment circuit may include a current source connected between the power supply terminal and the second terminal, and a resistor connected between the first terminal and the second terminal. The current source may be a variable current source capable of adjusting a current value such that a voltage generated across both terminals of the resistor increases and decreases in response to a change in an input voltage of the differential amplifier circuit.

In an embodiment of the present invention, the voltage adjustment circuit may be configured to be capable of generating a voltage which is lower than gate voltages or threshold voltages of the first PMOS transistor and the second PMOS transistor over a predetermined temperature range, and has a temperature coefficient of a polarity reverse to a polarity of a temperature coefficient of a voltage received at the gate of the first PMOS transistor.

In an embodiment of the present invention, the generated voltage may be 0.10 V or more and 0.35 V or less over the predetermined temperature range.

Effects of Invention

According to the present invention, even if the minimum operating voltage of the differential amplifier circuit in the reference voltage circuit is kept low, the saturation operation of each MOS transistor constituting the differential amplifier circuit can be stabilized under conditions where the voltage received at the differential amplifier circuit changes due to an external temperature change.

BRIEF DESCRIPTION OF DRAWINGS

FIG. 1 is a circuit diagram illustrating a configuration example of a reference voltage circuit according to an embodiment of the present invention.

FIG. 2 is a circuit diagram illustrating a configuration example of a differential amplifier circuit in the reference voltage circuit according to the present embodiment.

FIG. 3 is a circuit diagram illustrating a first configuration example of a voltage adjustment circuit of the differential amplifier circuit in the reference voltage circuit according to the present embodiment.

FIG. 4 is a circuit diagram illustrating a configuration example of a differential amplifier circuit in a reference voltage circuit according to a first comparative example.

FIG. 5 is a circuit diagram illustrating a configuration example of a differential amplifier circuit in a reference voltage circuit according to a second comparative example.

FIG. 6 is a circuit diagram illustrating a modification example (second configuration example) of the voltage adjustment circuit of the differential amplifier circuit in the reference voltage circuit according to the present embodiment.

DESCRIPTION OF EMBODIMENTS

Hereinafter, a reference voltage circuit according to an embodiment of the present invention will be described with reference to the drawings.

[Overall configuration of reference voltage circuit]

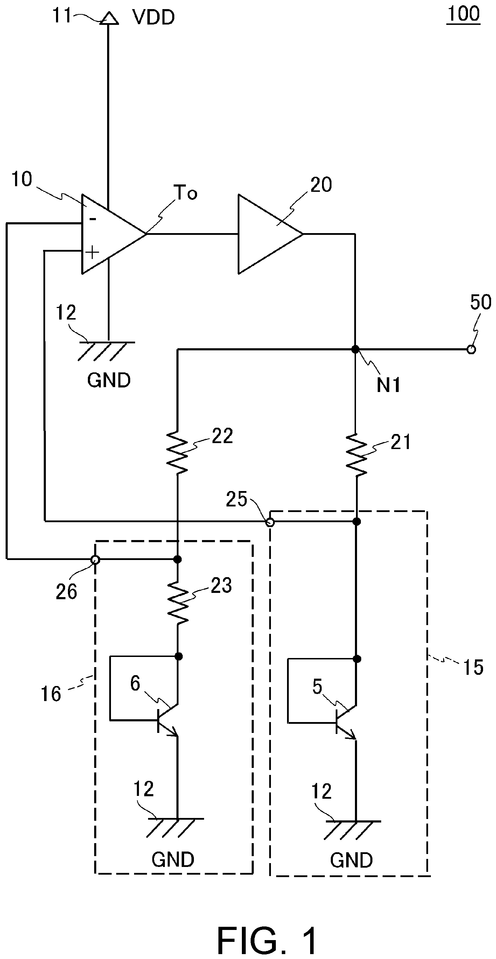

FIG. 1 is a circuit diagram illustrating an overall configuration of a reference voltage circuit 100 serving as an example of a reference voltage circuit according to an embodiment of the present invention.

The reference voltage circuit 100 includes a VDD terminal 11 which supplies a voltage VDD as an example of a power supply voltage, a GND terminal 12 which supplies a ground voltage GND different from the voltage VDD, a VREF output port 50 which outputs a reference voltage VREF, a differential amplifier circuit 10, a buffer 20, a reference voltage source 15, a reference voltage source 16, a resistor 21, and a resistor 22.

The reference voltage source 15 includes an output port 25 and a transistor 5 as a first NPN transistor.

The reference voltage source 16 includes an output port 26, a resistor 23, and a transistor 6 as a second NPN transistor.

The differential amplifier circuit 10 includes a power supply terminal, a ground terminal, an inverting input port (-), a non-inverting input port (+), and an output port To. The power supply terminal of the differential amplifier circuit 10 is connected to the VDD terminal 11. The ground terminal of the differential amplifier circuit 10 is connected to the GND terminal 12. The non-inverting input port (+) is connected to the output port 25. The inverting input port (-) is connected to the output port 26. The output port To is connected to the VREF output port 50 via the buffer 20. The resistor 21 and the resistor 22 are connected to a connection point N1 between the buffer 20 and the VREF output port 50.

Herein, of two terminals of the resistor 21, one terminal connected to the connection point N1 will be referred to as a first terminal, and the other terminal will be referred to as a second terminal. A first terminal and a second terminal of the resistor 22 will also be referred to in the same manner as the first terminal and the second terminal of the resistor 21.

An emitter of the transistor 5 is connected to the GND terminal 12. A base and a collector of the transistor 5 are directly connected, and are connected to the output port 25 of the reference voltage source 15 and the second terminal of the resistor 21.

An emitter of the transistor 6 is connected to the GND terminal 12. A base and a collector of the transistor 6 are directly connected, and are connected to a first terminal of the resistor 23. A second terminal of the resistor 23 is connected to the output port 26 of the reference voltage source 16 and the second terminal of the resistor 22.

The operation of the reference voltage circuit 100 will be described. In this description, it is assumed that distributions of sizes of the resistor 21, the resistor 22, the resistor 23, the transistor 5, and the transistor 6 are appropriately selected in advance. If an output port of the buffer 20 is disconnected from the connection point N1 and the voltage at the connection point N1 is gradually increased from zero, the voltage at the output port 25 of the reference voltage source 15 will hardly increase from a specific value onward. On the other hand, in the case of the same increase pattern of the voltage at the connection point N1, the voltage at the output port 26 of the reference voltage source 16 is lower than the voltage at the output port 25 in the vicinity of zero, but continues to rise gradually even after reaching the specific value, and becomes higher than the voltage at the output port 25. In other words, a magnitude relationship between the voltage at the output port 25 and the voltage at the output port 26 reverses from midway onward.

Herein, if the voltage at the connection point N1 is adjusted such that the voltage at the output port 25 of the reference voltage source 15 and the voltage at the output port 26 of the reference voltage source 16 become equal to each other, the voltage at the connection point N1 becomes a constant voltage independent of factors such as temperature.

If the non-inverting input port (+) of the differential amplifier circuit 10 receives the voltage at the output port 25 of the reference voltage source 15, the inverting input port (-) receives the voltage at the output port 26 of the reference voltage source 16, the buffer 20 receives a signal from the output port To, and a current is supplied from the output port of the buffer 20 to the resistor 21 and the resistor 22 through the connection point N1, a constant reference voltage VREF independent of factors such as temperature as described above appears at the VREF output port 50 connected to the connection point N1.

[Differential amplifier circuit]

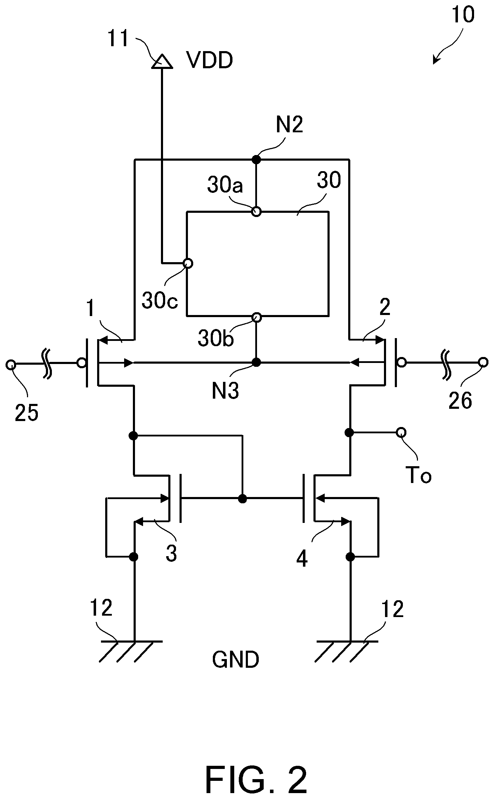

FIG. 2 is a circuit diagram illustrating a configuration example of the differential amplifier circuit 10 serving as an example of a differential amplifier circuit included in the reference voltage circuit according to the present embodiment.

The differential amplifier circuit 10 includes PMOS transistors 1 and 2 constituting a differential pair, NMOS transistors 3 and 4, and a voltage adjustment circuit 30 including a first terminal 30a, a second terminal 30b, and a power input terminal 30c. Herein, the non-inverting input port (+) and the inverting input port (-) of the differential amplifier circuit 10 correspond to a gate of the PMOS transistor 1 and a gate of the PMOS transistor 2, respectively. The power supply terminal of the differential amplifier circuit 10 corresponds to the power input terminal 30c in the voltage adjustment circuit 30. Further, the ground terminal of the differential amplifier circuit 10 corresponds to back gates and sources of the NMOS transistors 3 and 4. The output port To is connected to a connection point between a drain of the PMOS transistor 2 and a drain of the NMOS transistor 4.

The respective drains of the NMOS transistor 3 and the NMOS transistor 4 are connected to the respective drains of the PMOS transistor 1 and the PMOS transistor 2. The sources of the NMOS transistor 3 and the NMOS transistor 4 are connected to the GND terminal 12. The PMOS transistor 1 and the PMOS transistor 2 include a common source corresponding to a connection point N2 at which the sources of the PMOS transistor 1 and the PMOS transistor 2 are connected, and a common back gate corresponding to a connection point N3 at which the back gates of the PMOS transistor 1 and the PMOS transistor 2 are connected.

The voltage adjustment circuit 30 is a circuit having a function of adjusting the voltage applied between the first terminal 30a and the second terminal 30b. In the voltage adjustment circuit 30, the first terminal 30a is connected to the connection point N2, and the second terminal 30b is connected to the connection point N3. Further, the power input terminal 30c is connected to the VDD terminal 11. The voltage applied between the first terminal 30a and the second terminal 30b is configured to exhibit a positive temperature coefficient T2 (> 0) which is smaller than an absolute value of a temperature coefficient T1, from the viewpoint of reducing the influence on the negative temperature coefficient T1 (< 0) exhibited by a voltage received at the differential amplifier circuit 10, i.e., a voltage of a PNjunction element. Herein, since it is known that the temperature coefficient T1 is -2 mV/°C, the temperature coefficient T2 is set to [X1] mV/°C greater than 0. The temperature coefficient T2 is more preferably set to [1 mV/°C ≤ T2 ≤ 2 mV/°C], and further more preferably set to [2 mV/°C], for example.

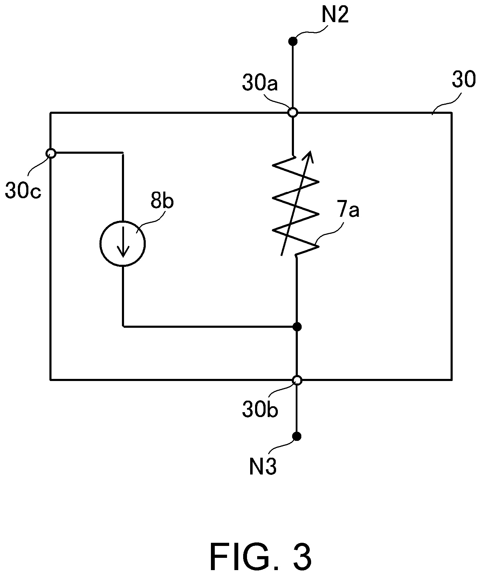

FIG. 3 is a circuit diagram illustrating a configuration example of the voltage adjustment circuit 30 serving as an example (first configuration example) of the voltage adjustment circuit in the differential amplifier circuit included in the reference voltage circuit according to the present embodiment.

The voltage adjustment circuit 30 includes a resistor which contains a variable resistor 7a having a resistance value of a positive temperature coefficient and configured to be capable of adjusting the resistance value, and a constant current source 8b which supplies a predetermined constant current. A first terminal and a second terminal of the variable resistor 7a are connected to the first terminal 30a and the second terminal 30b of the voltage adjustment circuit 30, respectively. A first terminal and a second terminal of the constant current source 8b are connected to the power input terminal 30c and the second terminal 30b of the voltage adjustment circuit 30, respectively. The voltage adjustment circuit 30 is configured to be capable of adjusting a voltage value of a voltage exhibiting a positive temperature coefficient applied between the first terminal 30a and the second terminal 30b by adjusting the resistance value of the variable resistor 7a.

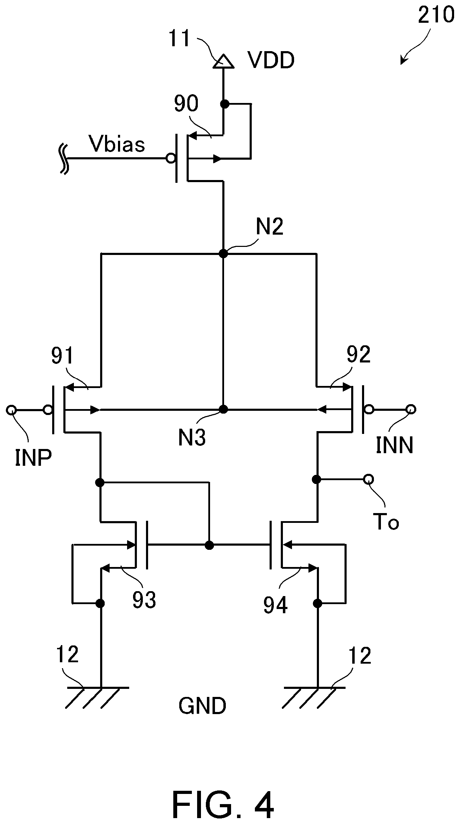

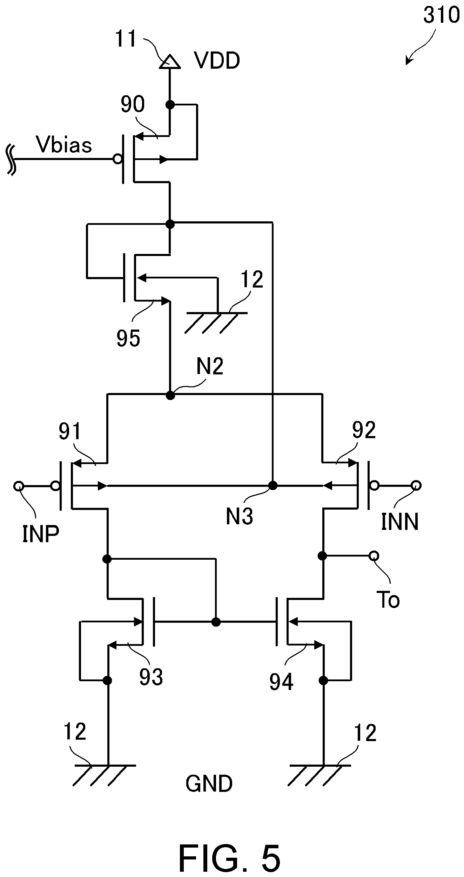

Next, the operation of the reference voltage circuit (First Example to Third Example: FIG. 1) including the differential amplifier circuit 10 will be described in comparison with a reference voltage circuit (First Comparative Example) including a differential amplifier circuit 210 (refer to FIG. 4 to be described later) and a reference voltage circuit (Second Comparative Example) including a differential amplifier circuit 310 (refer to FIG. 5 to be described later), focusing on the differential amplifier circuit 10 where differences are significant. To match the conditions with the differential amplifier circuit 10, it is assumed that voltages received at gates of the PMOS transistors 91 and 92 are the same as the voltages received at the gates of the PMOS transistors 1 and 2, i.e., the voltages outputted from the reference voltage sources 15 and 16.

(First Comparative Example)

FIG. 4 is a circuit diagram illustrating a configuration example of the differential amplifier circuit 210 of the reference voltage circuit according to First Comparative Example.

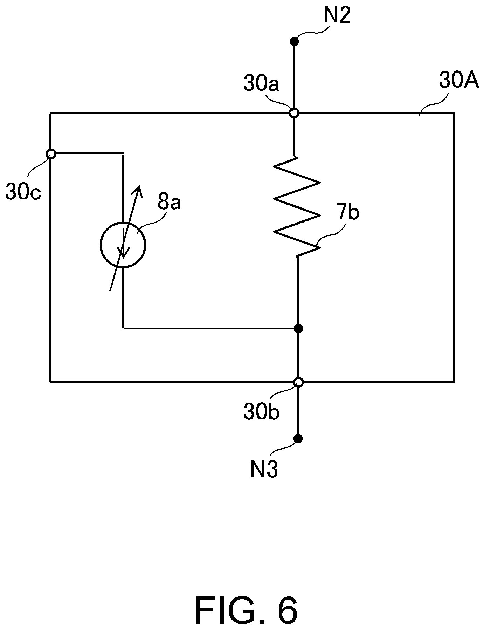

The differential amplifier circuit 210 includes a PMOS transistor 90 receiving a bias voltage Vbias at the gate, PMOS transistors 91 and 92 constituting a differential pair, and NMOS transistors 93 and 94. The differential amplifier circuit 210 is substantially equivalent to a differential amplifier circuit (3) illustrated in FIG. 6 of Patent Document 2.

The operation of the differential amplifier circuit 210 will be briefly described. In the differential amplifier circuit 210, the gate of the PMOS transistor 91 corresponding to a non-inverting input port INP, and the gate of the PMOS transistor 92 corresponding to an inverting input port INN, respectively receive voltages. To be comparable with the differential amplifier circuit 10, it is assumed that the voltages received at the gates of the PMOS transistors 91 and 92 are voltages based on the voltage of the PN junction element.

Voltages at the sources of the PMOS transistors 91 and 92 automatically reach voltages which are higher by absolute values of gate threshold voltages of the PMOS transistors 91 and 92, from a midpoint voltage (hereinafter referred to as a "common-mode input voltage") between the voltage at the gate of the PMOS transistor 91 and the voltage at the gate of the PMOS transistor 92.

Thus, ideally, a differential voltage between the voltage at the gate of the PMOS transistor 91 and the voltage at the gate of the PMOS transistor 92 appears proportionally to a difference between a drain current of the PMOS transistor 91 and a drain current of the PMOS transistor 92, independently of the common-mode input voltage. A current mirror circuit composed of the NMOS transistor 93 and the NMOS transistor 94 converts a change in the difference between the drain current of the PMOS transistor 91 and the drain current of the PMOS transistor 92 into a change in the voltage, and outputs the change in the voltage to the output port To of the differential amplifier circuit 210.

Herein, drain-source voltages of the PMOS transistors 91 and 92 will be described. The voltages at the sources of the PMOS transistors 91 and 92 are voltages higher than the voltages at the gates of the PMOS transistors 91 and 92 by the absolute values of the gate threshold voltages of the PMOS transistors 91 and 92. The voltage at the drain of the PMOS transistor 91 is the voltage at the drain and the gate of the NMOS transistor 93, since the drain and the gate of the NMOS transistor 93 are directly connected thereto.

Thus, a value obtained by adding the absolute value of the gate threshold voltage of the PMOS transistors 91 and 92 to the voltage at the gates of the PMOS transistors 91 and 92 and subtracting the gate threshold voltage of the NMOS transistor 93 becomes the absolute value of the drain-source voltage of the PMOS transistor 91.

Upon a temperature rise in and around the differential amplifier circuit 210, around the PMOS transistor 91: (I) the voltage received at the gate of the PMOS transistor 91 decreases, (II) the absolute value of the gate threshold voltage of the PMOS transistor 91 decreases, and (III) the gate threshold voltage of the NMOS transistor 93 decreases. Considering that the drain of the PMOS transistor 91 and the drain and the gate of the NMOS transistor 93 form a same node, since variations due to (II) and (III) lower the source voltage and the drain voltage of the PMOS transistor 91, respectively, in terms of the drain-source voltage of the PMOS transistor 91, these variations cancel each other out. As a result, among (I) to (III), only (I) the decrease in the voltage received at the gate of the PMOS transistor 91 affects the variation in the absolute value of the drain-source voltage of the PMOS transistor 91.

Upon a temperature rise in the reference voltage circuit including the differential amplifier circuit 210 and the reference voltage sources 15 and 16, the absolute value of the drain-source voltage of the PMOS transistor 91 decreases. Thus, with the rise in temperature exceeding a predetermined value, the absolute value of the drain-source voltage of the PMOS transistor 91 falls below a lower limit required to maintain the operation in a saturation region, and the operation in the saturation region can no longer be ensured.

(Second Comparative Example)

FIG. 5 is a circuit diagram illustrating a configuration example of the differential amplifier circuit 310 of the reference voltage circuit according to Second Comparative Example.

The differential amplifier circuit 310 differs from the differential amplifier circuit 210 in that the differential amplifier circuit 310 further includes an NMOS transistor 95, and there are no substantial differences in other aspects. Thus, in the description of the differential amplifier circuit 310, components which do not substantially differ from the components of the differential amplifier circuit 210 will be labeled with the same reference signs, and repeated descriptions thereof will be omitted.

A drain and a gate of the NMOS transistor 95 are connected to the source of the PMOS transistor 90 and the common back gate, i.e., the connection point N3, of the PMOS transistors 91 and 92. A source of the NMOS transistor 95 is connected to the common source, i.e., the connection point N2, of the PMOS transistors 91 and 92. A back gate of the NMOS transistor 95 is connected to the GND terminal 12.

In the differential amplifier circuit 310 configured in this manner, a substrate bias voltage $V_{BS}$ which is a voltage between the substrate (back gate) and the source of the PMOS transistors 91 and 92, becomes a voltage based on the PN junction within the NMOS transistor 95. However, since the temperature characteristic of the substrate bias voltage $V_{BS}$ in the differential amplifier circuit 310 becomes a negative temperature characteristic, upon a temperature rise in the reference voltage circuit including the differential amplifier circuit 310 and the reference voltage sources 15 and 16, the substrate bias voltage $V_{BS}$ in the differential amplifier circuit 310 also decreases, similarly to the voltage received at the gate of the PMOS transistor 91.

(First Example to Third Example)

On the other hand, in the differential amplifier circuit 10 including the voltage adjustment circuit 30, the voltage at the common back gate, i.e., the connection point N3, of the PMOS transistor 1 and the PMOS transistor 2 is raised by a potential difference generated between both terminals (first terminal 30a and second terminal 30b) of the voltage adjustment circuit 30. By adopting the configuration raising the voltage at the connection point N3, the absolute values of the effective gate threshold voltages of the PMOS transistors 1 and 2 are increased compared to the absolute values of the gate threshold voltages of the PMOS transistors 91 and 92, respectively.

Compared to the differential amplifier circuit 210, in the differential amplifier circuit 10, since the PMOS transistors 1 and 2 have absolute values of the drain-source voltages which are substantially greater than the absolute values of the drain-source voltages of the PMOS transistors 91 and 92, the operation in the saturation region can be ensured against a wider range of temperature rise. In other words, compared to the differential amplifier circuit 210, the temperature range in which the differential pair can be operated correctly can be expanded. Further, as described above, it is also important that the voltage difference generated in the voltage adjustment circuit 30 is appropriately small, corresponding to the small voltage caused by the temperature change in the gate voltage of the PMOS transistors 1 and 2, which is equivalent to the input voltage of the differential amplifier circuit.

The voltage adjustment circuit 30 creates a substrate bias effect in the PMOS transistors 1 and 2 by adjusting the voltage at both terminals to increase and decrease according to a change in the input voltage of the differential amplifier circuit 10. The voltage between the source and the substrate (back gate) of the PMOS transistors 1 and 2 will be referred to as the substrate bias voltage $V_{BS}$. Using the substrate bias voltage $V_{BS}$, a threshold voltage Vth of the PMOS transistors 1 and 2 is expressed by Equation (1) below.

[Math. (1)]

$$V_{th} = V_{FB} + 2\Phi_F + \frac{1}{C_{OX}}\sqrt{2\varepsilon q N_D(2\Phi_F + |V_{BS}|)} \quad \cdots (1)$$

Herein, $V_{FB}$ is a flat-band voltage, $2\Phi_F$ is a surface potential of the time when inversion is achieved, Cox is a gate oxide capacitance, $\varepsilon$ is a dielectric constant, q is an elementary charge, and $N_D$ is a donor density.

According to Equation (1), it is learned that the threshold voltage Vth of the PMOS transistors 1 and 2 increases as the absolute value $|V_{BS}|$ of the substrate bias voltage increases. With the voltage at the back gate increasing with respect to the voltage at the source, i.e., upon addition of a positive substrate bias voltage $V_{BS}$, a state is created (hereinafter referred to as a "reverse bias application state") in which a reverse bias is applied to a PN junction between an N-type well and a P-type channel formed by inversion on channel surfaces of the PMOS transistors 1 and 2. In the reverse bias application state, compared to a state in which a reverse bias is not applied, a depletion layer expands and a positive charge within the depletion layer increases. The increase in the positive charge within the depletion layer is required to be larger to increase the gate voltage for forming the channel, so the threshold voltage |Vth| of the PMOS transistors 1 and 2 is increased.

Further, to keep a minimum operating voltage capable of being used as the voltage VDD low, a drain-source voltage Vds at which the PMOS transistors 1 and 2 operate in saturation may be reduced. The drain-source voltage Vds required for the saturation operation of the PMOS transistors 1 and 2 may be expressed using a gate-source voltage Vgs and the threshold voltage Vth.

$$Vds \geq Vgs - Vth \quad ... (2)$$

Thus, to reduce the drain-source voltage Vds at which the PMOS transistors 1 and 2 operate in saturation, "Vgs - Vth (= Vov)" may be reduced.

In the differential amplifier circuit 10 including the voltage adjustment circuit 30, the voltage difference between both terminals (first terminal 30a and second terminal 30b) of the voltage adjustment circuit 30 is adjusted to satisfy Equation (2) above within an expected usage temperature range. Herein, assuming operation at a constant voltage of 2 V as an example of a low voltage, the absolute value $|V_{BS}|$ of the substrate bias voltage is adjusted to a positive voltage of 0.36 V or less, since an upper limit satisfying Equation (2) is approximately 0.36 V.

However, if the absolute value $|V_{BS}|$ of the substrate bias voltage is low, the effect of threshold voltage increase due to the back gate effect cannot be sufficiently obtained. Thus, for example, the absolute value $|V_{BS}|$ is preferably adjusted to be 0.07 V or more and 0.36 V or less, and more preferably adjusted to a predetermined range including 0.2 V greater than 0.1 V and less than 0.3 V, i.e., in the vicinity of 0.2 V. In the present embodiment, three Examples have been prepared, in which the absolute value $|V_{BS}|$ of the substrate bias voltage is different from each other and is within a range of a positive voltage of 0.36 V or less. The three Examples will be referred to as First example, Second example, and Third example sequentially from a lowest absolute value $|V_{BS}|$ of the substrate bias voltage (refer to Table 1 below for details).

Further, by setting the temperature characteristic of the substrate bias voltage $V_{BS}$ in the voltage adjustment circuit 30 to be positive, in the case where a temperature change occurs in the reference voltage circuit 100, the substrate bias voltage $V_{BS}$ is changed in the reverse direction corresponding to the change in the voltage received at the gate of the PMOS transistor 1. In other words, in the case where the temperature rises in the reference voltage circuit 100, the voltage received at the gate of the PMOS transistor 1 decreases, but the substrate bias voltage $V_{BS}$ of the PMOS transistors 1 and 2 is changed in the reverse, rising direction.

Next, specific numerical value examples of First Example to Third Example, First Comparative Example, and Second Comparative Example will be described with reference to Table 1 and Table 2. Herein, Cases (1) to (5) in Table 1 and Table 2 correspond to First Comparative Example, First Example, Second Example, Third Example, and Second Comparative Example, respectively.

In Table 1, VDD1 is the voltage VDD required for the saturation operation of the PMOS transistor 1 or 91, VDD2 is the voltage VDD required for the saturation operation of the NMOS transistor 3 or 93, Vf is a collector voltage of the transistor 5, Vgsp is a gate-source voltage of the PMOS transistor 1 or 91, Vdsp is a drain-source voltage of the PMOS transistor 1 or 91, and Vgsn is a gate-source voltage of the NMOS transistor 3 or 93 and is the same as a drain-source voltage Vdsn of the NMOS transistor 3 or 93. $V_{I8}$ is an inter-terminal voltage of the constant current source 8b, and $V_{R7}$ is an inter-terminal voltage of the variable resistor 7a.

Further, a threshold voltage Vthp of the PMOS transistor 1 or 91 may be calculated by substituting $V_{R7}$ for the absolute value $|V_{BS}|$ of the substrate bias voltage in Equation (1). A threshold voltage Vthn of the NMOS transistor 3 or 93 is a value of the time when the absolute value $|V_{BS}|$ of the substrate bias voltage is 0 V in Equation (1).

Furthermore, the determination column in Table 1 illustrates results of determination based on Equation (2), and whether the PMOS transistor 1 or 91 and the NMOS transistor 3 or 93 satisfy Equation (3) and Equation (4) below is respectively indicated by presence and absence of a mark "∘". In the case where Equation (3) is satisfied, the mark "o" is labeled in the column of Equation (3) (presence of mark "∘"), and in the case where Equation (4) is satisfied, the mark "o" is labeled in the column of Equation (4).

$$Vdsp \geq Vgsp - Vthp \quad \ldots (3)$$

$$Vdsn \geq Vgsn - Vthn \quad \ldots (4)$$

[Table 1]

| CASE | TEMP [°C] | VDD1=Vf+Vgsp+$V_{I8}$+$V_{R7}$ VDD2=Vgsn+Vdsp+$V_{I8}$+$V_{R7}$ [V] | | | | | | | DETERMINATION | |
| | | Vf | Vgsp | Vgsn | Vdsp | $V_{I8}$ | $V_{R7}$ | Vthp | EQ.(3) | EQ.(4) |
|---|---|---|---|---|---|---|---|---|---|---|
| (1) | -40 | 0.70 | 1.00 | 1.00 | 0.70 | 0.20 | 0.00 | 0.70 | ○ | ○ |
| | 125 | 0.40 | 1.30 | 1.00 | 0.90 | 0.20 | 0.00 | 0.40 | ○ | ○ |
| (2) | -40 | 0.70 | 0.95 | 1.00 | 0.65 | 0.20 | 0.07 | 0.72 | ○ | ○ |
| | 125 | 0.40 | 1.10 | 1.00 | 0.70 | 0.20 | 0.10 | 0.47 | ○ | ○ |
| (3) | -40 | 0.70 | 0.85 | 1.00 | 0.50 | 0.20 | 0.20 | 0.80 | ○ | ○ |
| | 125 | 0.40 | 1.05 | 1.00 | 0.50 | 0.20 | 0.23 | 0.55 | ○ | ○ |
| (4) | -40 | 0.70 | 0.80 | 1.00 | 0.40 | 0.20 | 0.30 | 0.83 | ○ | ○ |
| | 125 | 0.40 | 0.95 | 1.00 | 0.35 | 0.20 | 0.36 | 0.60 | ○ | ○ |
| (5) | -40 | 0.70 | 0.80 | 1.00 | 0.30 | 0.20 | 0.40 | 0.85 | ○ | ○ |
| | 125 | 0.40 | 0.75 | 1.00 | 0.15 | 0.20 | 0.50 | 0.65 | ○ | ○ |

Table 1 illustrates whether each Case (1) to (5) satisfies Equation (3) and Equation (4), respectively, at -40°C serving as a representative value on a low-temperature side, and at 125°C serving as a representative value on a high-temperature side, within a continuous temperature range including at least -40°C to 125°C. Herein, the threshold voltage Vthp of the PMOS transistor 1 or 91 may be calculated by substituting $V_{R7}$ for the absolute value $|V_{BS}|$ of the substrate bias voltage in Equation (1). The threshold voltage Vthn of the NMOS transistor 3 or 93 is a value of the time when the absolute value $|V_{BS}|$ of the substrate bias voltage is 0 V in Equation (1).

In Case (1) (First Comparative Example), although $V_{R7} = |V_{BS}|$ is a fixed value of 0 V and cannot be adjusted, VDD1 and VDD2 satisfying Equation (3) and Equation (4) above are present at -40°C and 125°C. Case (5) (Second Comparative Example) is an example in which the differential amplifier circuit 310 is configured to obtain $V_{R7} = |V_{BS}|$ being 0.4 V at -40°C and being 0.5 V at 125°C, by connecting the NMOS transistor 95. In Case (5) (Second Comparative Example), VDD1 and VDD2 satisfying Equation (3) and Equation (4) above are present. In Case (5), to change $V_{R7} = |V_{BS}|$, it is required to change the characteristic of the NMOS transistor 95 or change the operating condition, which is difficult compared to the case of adjusting the resistance value of a resistor or the current value flowing through the resistor.

In contrast, in Case (2) (First Example), Case (3) (Second Example), and Case (4) (Third Example), since $V_{R7} = |V_{BS}|$ can be adjusted by adjusting the resistance value of the variable resistor 7a, a value of $V_{R7}$ satisfying Equation (2) above can be searched for to change the threshold voltage Vthp of the PMOS transistors 1 and 2. While maintaining a similar level of configurational simplicity without increasing the number of components compared to the differential amplifier circuit 310, adjustment of $V_{R7} = |V_{BS}|$ in the differential amplifier circuit 10 is easy compared to adjustment of $V_{R7} = |V_{BS}|$ in the differential amplifier circuit 310. In Cases (2), (3), and (4) illustrated in Table 1, by adjusting the resistance value of the variable resistor 7a, $V_{R7} = |V_{BS}|$ can be respectively adjusted to 0.07 V, 0.20 V, and 0.30 V at -40°C and to 0.10 V, 0.23V, and 0.36 V at 125°C, and in those cases, VDD1 and VDD2 satisfying Equation (2) above can be obtained.

[Table 2]

| CASE | TEMP [°C] | VDD1 [V] | VDD2 [V] | VDDmax [V] | DETERMINATION VDD ≦ 2V |
|------|-----------|----------|----------|------------|------------------------|
| (1) | -40 | 1.90 | 1.90 | 1.90 | × |
| | 125 | 1.90 | 2.10 | 2.10 | |
| (2) | -40 | 1.92 | 1.92 | 1.92 | ○ |
| | 125 | 1.80 | 2.00 | 2.00 | |
| (3) | -40 | 1.95 | 1.90 | 1.95 | ○ |
| | 125 | 1.88 | 1.93 | 1.93 | |
| (4) | -40 | 2.00 | 1.90 | 2.00 | ○ |
| | 125 | 1.91 | 1.91 | 1.91 | |
| (5) | -40 | 2.10 | 1.90 | 2.10 | × |
| | 125 | 1.85 | 1.85 | 1.85 | |

Table 2 illustrates calculation results of VDD1 and VDD2 presented in Table 1. The minimum operating voltage in the differential amplifier circuits 10, 210, and 310 (FIG. 2, FIG. 4, and FIG. 5) is VDDmax illustrated in Table 2. VDDmax is the higher one between VDD1 and VDD2. In the determination column, a mark "o" indicates that VDDmax is less than 2 V, and a mark "×" indicates that VDDmax is not less than 2 V, i.e., VDDmax is 2 V or higher.

As illustrated in Table 2, in Case (1) and Case (5), i.e., the differential amplifier circuit 210 and the differential amplifier circuit 310, VDDmax, i.e., the minimum operating voltage, exceeds 2.0 V. Essentially, in a voltage range (Case (1)) in which $V_{R7} = |V_{BS}|$ is less than 0.07 V or a voltage range (Case (5)) in which $V_{R7} = |V_{BS}|$ is 0.4 V or higher, even if the PMOS transistors 91 and 92 and the NMOS transistors 93 and 94 can be used in the saturation region, VDDmax, i.e., the minimum operating voltage, cannot be kept at 2.0 V or less.

In contrast, in Cases (2), (3), and (4), i.e., the differential amplifier circuit 10, VDDmax, i.e., the minimum operating voltage, is below 2.0 V. Thus, in the reference voltage circuit 100 including the differential amplifier circuit 10, $V_{R7} = |V_{BS}|$ is configured to be a positive voltage of approximately 0.36 V or less, for example, preferably within a range of 0.07 V or more and 0.36 V or less (approximately 0.10 V or more and 0.35 V or less), and more preferably in a range of the vicinity of 0.2 V, in which VDDmax is less than 2.0 V and the PMOS transistors 1 and 2 and the NMOS transistors 3 and 4 are capable of being used in the saturation region. With the above configuration, it is learned that the PMOS transistors 1 and 2 and the NMOS transistors 3 and 4 can be used in the saturation region while keeping VDDmax, i.e., the minimum operating voltage, at a low voltage of 2.0 V or less.

As described above, the reference voltage circuit 100 includes the differential amplifier circuit 10 including the voltage adjustment circuit 30 capable of easily adjusting the substrate bias voltage $V_{BS}$ at the PMOS transistors 1 and 2. By including the differential amplifier circuit 10, the reference voltage circuit 100 can adjust and apply a voltage between the common source and the common back gate of the PMOS transistors 1 and 2 such that the potential of the common back gate becomes higher than the potential of the common source. Since the potential difference between the common source and the common back gate of the PMOS transistors 1 and 2 is adjustable, the magnitude of the back gate effect imparted to the PMOS transistors 1 and 2 is adjustable.

Since the reference voltage circuit 100 includes the differential amplifier circuit 10 configured to be capable of adjusting the magnitude of the back gate effect imparted to the PMOS transistors 1 and 2, even if the drain-source voltage of the PMOS transistors 1 and 2 is configured to be small in a state in which the substrate bias effect is not imparted, stable operation of the PMOS transistors 1 and 2 and the NMOS transistors 3 and 4 in the saturation region can still be ensured in an environment in which variations in the input voltage occur due to temperature changes.

From another perspective, in the case where an operable range in the saturation region of the differential amplifier circuit 10 is designed to be similar to an operable range in the saturation region of the differential amplifier circuit 210, the absolute value of the drain-source voltage of the PMOS transistors 1 and 2 in a state in which the substrate bias effect is not imparted can be designed to be smaller than the absolute value of the drain-source voltage of the PMOS transistors 91 and 92. In other words, the voltage VDD supplied to the differential amplifier circuit 10 can be made lower than the voltage VDD supplied to the differential amplifier circuit 210.

According to the reference voltage circuit 100, the voltage adjusted by the voltage adjustment circuit 30, i.e., the substrate bias voltage $V_{BS}$ of the PMOS transistors 1 and 2, exhibits a positive temperature coefficient, which is a polarity reverse to the temperature coefficient of the voltage received at the gate of the PMOS transistor 1 of the differential amplifier circuit 10. Thus, according to the reference voltage circuit 100, in response to a change in the voltage received at the gate of the PMOS transistor 1, the substrate bias voltage $V_{BS}$ of the PMOS transistors 1 and 2 can be changed in a direction reverse to such a change.

Further, by including the differential amplifier circuit 10, since the reference voltage circuit 100 can easily adjust the magnitude of the substrate bias effect to be imparted, the reference voltage circuit 100 can adjust to a substrate bias voltage $V_{BS}$ which both achieves a lower minimum operating voltage and ensures stable operation of the PMOS transistors 1 and 2 and the NMOS transistors 3 and 4 in the saturation region. More specifically, the inter-terminal voltage between the first terminal 30a and the second terminal 30b is designed to be approximately 0.1 V to 0.3 V over a predetermined temperature range such as a temperature range in which usage is expected. Since the absolute value of the gate threshold voltage of the PMOS transistors 1 and 2 increases by an amount corresponding to the set inter-terminal voltage between the first terminal 30a and the second terminal 30b, the voltage at the source of the PMOS transistors 1 and 2 increases accordingly. As a result, the absolute value of the drain-source voltage of the PMOS transistors 1 and 2 increases, and stable operation of the differential amplifier circuit 10 becomes possible.

Thus, according to the reference voltage circuit of the present embodiment, even if the minimum operating voltage of the differential amplifier circuit is kept low, under conditions where the voltage received at the differential amplifier circuit changes due to an external temperature change, the saturation operation of each MOS transistor constituting the differential amplifier circuit can still be stabilized. According to the reference voltage circuit of the present embodiment, the minimum operating voltage capable of being used as the power supply voltage VDD can be kept low. Thus, the reference voltage circuit of the present embodiment can contribute to energy conservation of a semiconductor integrated circuit such as a linear regulator including the reference voltage circuit of the present embodiment.

The present invention is not limited to the above-described embodiments alone, and at the implementation stage, the present invention may be implemented in various forms other than the above-described embodiments. Various omissions, additions, substitutions, or modifications may be made within the scope of the invention without departing from the spirit of the invention. For example, the reference voltage circuit 100 illustrated in FIG. 1 includes the buffer 20, but the buffer 20 may also be omitted. In other words, in the reference voltage circuit according to the present embodiment, a configuration without a buffer may be adopted.

Further, although the differential amplifier circuit 10 described above is an example which includes the voltage adjustment circuit 30, the differential amplifier circuit 10 may also include a voltage adjustment circuit 30A (refer to FIG. 6) instead of the voltage adjustment circuit 30.

FIG. 6 is a circuit diagram illustrating a configuration example of the voltage adjustment circuit 30A serving as a modification example (second configuration example) of the voltage adjustment circuit of the differential amplifier circuit in the reference voltage circuit according to the present embodiment.

The voltage adjustment circuit 30A includes a fixed resistor 7b having a predetermined resistance value and a variable current source 8a configured to be capable of adjusting a current value supplied. The voltage adjustment circuit 30A is configured to be capable of adjusting the voltage between the first terminal 30a and the second terminal 30b. According to the voltage adjustment circuit 30A, a first terminal and a second terminal of the fixed resistor 7b are connected to the first terminal 30a and the second terminal 30b of the voltage adjustment circuit 30A, respectively. A first terminal and a second terminal of the variable current source 8a are connected to the power input terminal 30c and the second terminal 30b of the voltage adjustment circuit 30A, respectively.

In this manner, the voltage adjustment circuit 30A differs from the voltage adjustment circuit 30 in that the voltage adjustment circuit 30A includes the fixed resistor 7b instead of the variable resistor 7a and includes the variable current source 8a instead of the constant current source 8b, and does not substantially differ from the voltage adjustment circuit 30 in other aspects. In the voltage adjustment circuit 30A, the voltage between the first terminal 30a and the second terminal 30b is adjusted by adjusting the current value of the current supplied by the variable current source 8a.

These embodiments and modifications thereof are included in the scope and spirit of the invention, and are included within the scope of the invention described in the claims and equivalents thereof.

Reference Signs List

100 Reference voltage circuit
10 Differential amplifier circuit
11 VDD terminal
12 GND terminal
1 PMOS transistor
2 PMOS transistor
3 NMOS transistor
4 NMOS transistor
15 Reference voltage source
16 Reference voltage source
30, 30A Voltage adjustment circuit
7a Variable resistor
7b Fixed resistor
8a Variable current source
8b Constant current source
21, 22, 23 Resistor
5, 6 Transistor

**Claims**

1. A reference voltage circuit (100) including a differential amplifier circuit (10), the differential amplifier circuit (10) comprising:

    a first PMOS transistor (1) containing a gate corresponding to a first input port (25), a source, and a drain;
    a second PMOS transistor (2) containing a gate corresponding to a second input port (26), a source connected to the source of the first PMOS transistor (1), a back gate connected to the back gate of the first PMOS transistor (1), and a drain;
    a first NMOS transistor (3) containing a drain connected to the drain of the first PMOS transistor (1), a gate connected to the drain of the first NMOS transistor (3) and the drain of the first PMOS transistor (1), a back gate, and a source connected to the back gate of the first PMOS transistor (1) and a ground terminal (12);
    a second NMOS transistor (4) containing a drain connected to the drain of the second PMOS transistor (2), a gate connected to the drain of the second NMOS transistor (4), a back gate, and a source connected to the back gate of the first PMOS transistor (1) and the ground terminal (12); and
    a voltage adjustment circuit (30, 30A) comprising: a first terminal (30a) connected to commonly connected sources of the first PMOS transistor (1) and the second PMOS transistor (2); a second terminal (30b) connected to commonly connected back gates of the first PMOS transistor (1) and the second PMOS transistor (2); and a power input terminal (30c) connected to a power supply terminal (11), the voltage adjustment circuit (30, 30A) being configured such that the voltage generated between the first terminal (30a) and the second terminal (30b) increases and decreases in response to a change in an input voltage of the differential amplifier circuit (10).

2. The reference voltage circuit (100) according to claim 1, wherein

    the voltage adjustment circuit (30) comprises a current source (8b) connected between the power input terminal (30c) and the second terminal (30b), and a resistor (7a) connected between the first terminal (30a) and the second terminal (30b), and
the resistor (7a) comprises a variable resistor which has a temperature coefficient of a polarity reverse to a polarity of a temperature coefficient of a voltage received at the gate of the first PMOS transistor (1) and has a variable range of a resistance value.

3. The reference voltage circuit (100) according to claim 1, wherein

the voltage adjustment circuit (30A) comprises a current source (8a) connected between the power supply terminal (30c) and the second terminal (30b), and a resistor (7b) connected between the first terminal (30a) and the second terminal (30b), and
the current source (8a) is a variable current source configured to adjust a current value such that a voltage generated across both terminals of the resistor (7b) increases and decreases in response to a change in an input voltage of the differential amplifier circuit (10).

4. The reference voltage circuit (100) according to any one of claims 1 to 3, wherein
the voltage adjustment circuit (30, 30A) is configured to generate a voltage which is lower than gate voltages or threshold voltages of the first PMOS transistor (1) and the second PMOS transistor (2) over a predetermined temperature range, and has a temperature coefficient of a polarity reverse to a polarity of a temperature coefficient of a voltage received at the gate of the first PMOS transistor (1).

5. The reference voltage circuit (100) according to claim 4, wherein the generated voltage is 0.10 V or more and 0.30 V or less over the predetermined temperature range.

100

FIG. 1

FIG. 2

FIG. 3

210

11 — △ VDD

90

Vbias

N2

91 92

INP INN

N3

To

93 94

12 12

GND

# FIG. 4

310

## FIG. 5

FIG. 6

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 147 548 A (DOYLE JAMES T [US]) 14 November 2000 (2000-11-14) | 1,3 | INV. G05F3/30 |
| A | * abstract; figures 3,6 * | 2,4,5 | H03F3/45 |
| A | US 2021/250005 A1 (SHIINA YOSHIOMI [JP]) 12 August 2021 (2021-08-12) * abstract; figures 1-3 * | 1-5 | |
| A | US 2019/052239 A1 (IWAMOTO MOTOMITSU [JP]) 14 February 2019 (2019-02-14) * abstract; figure 6 * | 1-5 | |
| A | US 2023/016043 A1 (SUNTKEN ARTUR WILHELM [ZA]) 19 January 2023 (2023-01-19) * figure 3 * | 1-5 | |
| A | JP 2005 136473 A (NEC ELECTRONICS CORP) 26 May 2005 (2005-05-26) * abstract; figure 1 * | 1-5 | |
| | | | **TECHNICAL FIELDS SEARCHED (IPC)** |
| | | | G05F H03F |

The present search report has been drawn up for all claims

| Place of search | Date of completion of the search | Examiner |
|---|---|---|
| The Hague | 24 January 2025 | Arias Pérez, Jagoba |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

............................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 2302

This annex lists the patent family members relating to the patent documents cited in the above-mentioned European search report.
The members are as contained in the European Patent Office EDP file on
The European Patent Office is in no way liable for these particulars which are merely given for the purpose of information.

24-01-2025

| Patent document cited in search report | | Publication date | Patent family member(s) | | Publication date |
|---|---|---|---|---|---|
| US 6147548 | A | 14-11-2000 | US | 6052020 A | 18-04-2000 |
| | | | US | 6147548 A | 14-11-2000 |
| | | | US | 6281743 B1 | 28-08-2001 |
| US 2021250005 | A1 | 12-08-2021 | CN | 113258892 A | 13-08-2021 |
| | | | JP | 7479753 B2 | 09-05-2024 |
| | | | JP | 2021125830 A | 30-08-2021 |
| | | | US | 2021250005 A1 | 12-08-2021 |
| US 2019052239 | A1 | 14-02-2019 | JP | 2019033414 A | 28-02-2019 |
| | | | US | 2019052239 A1 | 14-02-2019 |
| US 2023016043 | A1 | 19-01-2023 | CN | 112953540 A | 11-06-2021 |
| | | | EP | 4073935 A1 | 19-10-2022 |
| | | | JP | 2023506449 A | 16-02-2023 |
| | | | NL | 2024414 B1 | 01-09-2021 |
| | | | TW | 202123616 A | 16-06-2021 |
| | | | US | 2023016043 A1 | 19-01-2023 |
| | | | WO | 2021116796 A1 | 17-06-2021 |
| | | | ZA | 202206310 B | 22-02-2023 |
| JP 2005136473 | A | 26-05-2005 | NONE | | |

EPO FORM P0459

For more details about this annex : see Official Journal of the European Patent Office, No. 12/82

**REFERENCES CITED IN THE DESCRIPTION**

**Patent documents cited in the description**

- JP H10303658 A

- JP 2005136473 A